# EUROPEAN PATENT APPLICATION

(11) **EP 1 074 849 A2**
(43) Date of publication of application: **07.02.2001**
(21) Application number: 00306477.1
(22) Date of filing: 28.07.2000
(51) Int. Cl.: G01R 31/08

(54) **Fault detection in electrical transmission lines**

(30) Priority: 03.08.1999 GB 9918103
(71) Applicant: Alstom UK Limited, Rugby, Warwickshire CV21 1TB (GB)
(72) Inventor: Heggie, Graeme, Stone ST15 8YS (GB); Pickering, Steven Dafydd Alan, Lichfield WS13 8AB (GB)
(74) Representative: Dargavel, Laurence Peter

(57) **Abstract**

Fault detection in a multi-phase electrical transmission line (30, 32, 34) is accomplished by providing detectors (36, 38, etc.) at each end of a line section which detect the current flowing into and out of the line section and output a value of the current. The outputs of the detectors are processed in a microprocessor-controlled relay unit (80, 82, 84) by calculating the phasor relationship between the instantaneous current flowing in the line section and the voltage, thereby determining whether there is a component of the current vector in the same direction as the voltage vector. If there is a component of current in phase with the voltage, then a fault is present in that line section.

## Description

This invention relates to an apparatus and method for providing fault protection of electric circuits, generally but not exclusively in multi-phase transmission systems.

It is well known that faults occur within electric circuits, and it is also known to provide apparatus to isolate the fault before excessive currents can flow through or around the fault leading to damage and high risks of injury to persons around the fault.

Prior art protection systems include apparatus wherein current transformers are provided on each end of a line to be protected. The current induced in the current transformers is measured. If there is difference between the currents flowing through the current transformers a fault has occurred on the line and protective relays trip to isolate the line.

The above scheme is a simple overview and suffers from a number of drawbacks. It is equally important when providing fault protection on a line to prevent the protection from being triggered by faults outside the line as it is to protect the line from faults within the line. The scheme outlined above would not necessarily be able to differentiate from a fault within the line and one outside the line, leading to false trips where saturation of the current transformers has occurred.

Therefore, there are many well known improvements to the basic scheme outlined above. One such improvement is the use of relay bias in which the level of current needed to operate the device is increased in proportion to the level of the fault current/load current magnitude. This however, has the undesirable effect of reducing the sensitivity of the device for low current level faults. Low current level faults may occur when the fault is to earth and the current is limited by fault resistance or an earthing impedance.

One of the more effective improvements is known as Neutral Differential Protection for protecting multi phase lines against earth faults. In this protection scheme a so-called "core balance" current transformer is provided in addition to current transformers for each phase. The core balance transformer passes around all of the phases and therefore detects neutral current. (The skilled person will appreciate that the vector sum of currents within a multiphase system sums to zero). If neutral current flows then there is a fault within one of the phases. Comparing the readings from the core balance transformers at each end of the protected line it is possible to determine whether the fault is inside or outside of the protected line. If the current reading at the core balance transformer is different at each end then the fault is inside the line and the protective relays can be caused to trip. Various thresholds are applied to ensure that false trips are less likely to occur. However, the neutral differential protection scheme can still be falsely triggered in some circumstances.

The skilled person will appreciate that any line is generally capacitively coupled to ground and that therefore in an a.c. system there will always be a current to ground through that capacitive coupling. This will occur from each of the phases in a multiphase system. In systems which have a solid earth link (i.e. low resistance to ground) this capacitive current is insignificant when compared to any fault currents which may flow and the neutral differential protection scheme can generally still protect the line.

However, in systems designed to be fault tolerant which have either a high earth impedance, or isolated earth, fault currents to earth are greatly reduced. In such systems the current to ground through the capacitive coupling is about the same magnitude as in systems with a solid earth link (The current through the capacitive coupling is independent of the value of the impedance to earth of the supply). Therefore, the current through the capacitive coupling can be of the same magnitude as a fault current to earth due to the large reduction in the fault current because of the high earth impedance. Thus, the neutral differential protection system can have trouble distinguishing between faults occurring within the protected line and outside the protected line, which can lead to false trips.

Such false trips can be dangerous. If the protected lines are feeders to various installations requiring power running from the same source it can be dangerous for feeders to trip due to faults in other feeders. One feeder may be supplying a hospital another a town, etc. Therefore, it is not desirable for either to lose power because of a fault in the feeder of the other.

According to a first aspect of the invention there is provided a fault detection apparatus adapted to detect a fault on a line section carrying more than one electrical phase the apparatus having;
detecting means provided at each end of the line section adapted to measure and output the current in the line section;
processing means adapted to measure the outputs from the detecting means; and
said processing means being adapted to calculate for the line section the phasor relationship between the instantaneous current flowing into the line section and the voltage and to determine whether there is a component of the current vector in the same direction as the voltage vector.

An advantage of such a system is that in systems with high earth impedance it is more tolerant of faults outside the protected line and therefore less likely to generate false detection of faults than other detection or protection schemes, for example the neutral differential protection.

The voltage detected by the processing means may be the instantaneous residual line voltage.

The detecting means may comprise one or more transformers, providing a convenient way of detecting the voltage and current associated with the line.

The or each transformer may be adapted to measure the neutral current flowing in the line. This is advantageous because in a line with two or more electrical phases the sum of the instantaneous phasor currents will be substantially zero. Therefore, in a healthy system neutral current will be substantially zero.

This may also mean that the detecting means can be made more sensitive. A line may carry 1000's of amps requiring the detecting means to be able to measure this value. However, the neutral current is likely to be substantially zero. By arranging matters so that it is the neutral current which is to be detected the detecting means may be made much more sensitive since it need only be arranged to detect small currents. If transformers are used for the detecting means they may be at least substantially an order of magnitude more sensitive than if the current is directly measured in the line.

The detecting means may be a core balance transformer. Such transformers generally are a coil surrounding all of the phases of a line so that the neutral current flowing through the line is measured, which will generally be substantially zero amps.

Alternatively, or additionally, a transformer may be provided for each phase of the line. An output of these transformers may be connected to a star point. A further transformer may be connected to a line connected to the star point. The detecting means may comprise the further transformer. The skilled person will appreciate that the star point of the commoned transformers is a neutral point and that therefore the further transformer detects the neutral current in the much the same manner as a core balance transformer.

The apparatus may comprise an isolation means adapted to isolate the line which may be if a current is detected in phase with the line voltage. This is advantageous because it allows the fault to be isolated. Preferably, the isolation means is adapted to be controlled by the processing means.

The processing means may comprise thresholding means adapted to trigger the isolation means if the component of current in phase with the line voltage is above a predetermined threshold. This is advantageous because it helps to reduce the likelihood of false operations of the isolation means.

Conveniently the processing means is adapted to calculate the residual power component in the line due to the component of current in phase with the voltage. This is advantageous because the fault tolerance of lines is often quoted/calculated as a power and therefore using this quantity may make the apparatus easier to set and operate.

The processing means may be provided with an input means which may allow the operation of the apparatus to be modified to suit a user's particular requirement. For example, the threshold at which the thresholding means is adapted to operate may be adjusted. The input means may comprise a keyboard, or a keypad or the like.

Preferably the apparatus is adapted to protect a three phase line. Such an apparatus being desirable due to the widespread use of three phase supplies.

Conveniently the processing means is connected to the detecting means at each end region of the line by a link, which may be a communications link. The skilled person will appreciate that the protected line may be a portion of a transmission line covering many kilometres and as such a communication link may be necessary to provide the processing means to the detecting means.

The communications link may be any one of the following: a radio link, microwave link, fibre optic link, cable link, telephone link. The skilled person will appreciate the nature of the link required.

The fault detection provided by the apparatus may be thought of as zero sequence power differential protection. The apparatus may be adapted to provide known fault detection techniques in addition to zero sequence power differential protection (may be neutral differential protection).

According to a second aspect of the invention there is provided a method of detecting a fault on an a.c. line having two or more electrical phases flowing therethrough, the method comprising:
a. detecting the current flowing into and out of the line;
b. determining whether there is an imbalance in the detected currents;
c. if there is an imbalance determining whether there is a component of current in phase with the voltage vector of the line; and
d. if there is a component of current in phase with the voltage determining that a fault is present within that line.

Such a method is advantageous because it is capable of determining whether or not the fault is occurring within the line or external to the line better than prior art systems. This is advantageous because faults should not be acted upon by protection associated with a particular line if the fault is external to that line, otherwise power may be lost to places where there was no need to lose power.

Preferably the method further comprises isolating the line if a fault is detected within the line.

The method may comprise detecting the neutral current flowing in the line which is advantageous because it is generally much smaller than the currents flowing in the individual phases and therefore may be measured more accurately because a meter sensitive to small currents may be used.

The method may be especially applicable to systems having an insulated earth, a high impedance to earth or systems earthed via a Petersen coil. This is advantageous because it has previously been hard to determine whether a fault occurred within a line or external to a line in such systems due to the relatively low fault currents which occur in such systems.

The method may be thought of as discounting capacitive charging current of the line, from the current flowing through the line. This is advantageous because this can have substantially the same value in a line with a fault present and one without a fault.

The method may discount the capacitive charging current by removing current phasors with a 90° phase shift from the voltage phasor.

The method may comprise thresholding any current detected in phase with the voltage on the line and determining that a fault has occurred if the threshold is exceeded. This is advantageous because it helps to reduce false determinations that a fault is present.

The method may comprise providing know fault detection schemes (which may be neutral current differential protection) in addition to the method of the invention. This is advantageous because the method according to the invention is only suitable for detecting earth faults and by providing additional protection schemes may allow the line section to be fully protected.

There now follows by way of example only a detailed description of invention with reference to the accompanying drawings of which:
**Figure 1** shows a schematic representation of a basic line protection system;
**Figure 2** shows a schematic representation three phase distribution network;
**Figure 3** shows the network of figure in which a fault has occurred;
**Figure 4** shows a phasor diagram for currents and voltages within the network of Figure 2; and
**Figure 5** shows a zero sequence network diagram for the fault occurring in Figure 3.

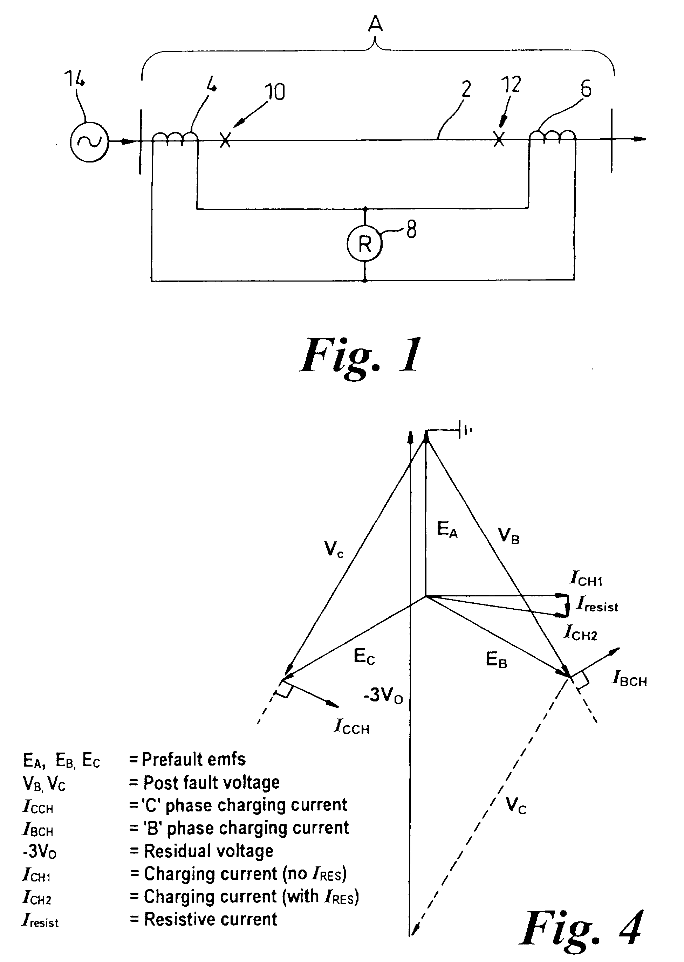

Figure 1 shows a line 2, which may be multiphase, having a protected region A. At each end region of the protected region A current transformer (CT) 4, 6 is provided. The current transformers 4, 6 are connected to a protection relay 8 which monitors the outputs from the current transformers 4, 6 to determine whether a fault condition has occurred. Trips 10, 12 are provided to isolate the line on the occurrence of a fault, and are operated by the relay 8. Current is fed down the line 2 by a source 14.

There are two equally important criteria which the relay 8 must satisfy. It must be tolerant of faults outside the protected line A but must be triggered by faults within the protected line A.

If there is no fault condition substantially all of the current entering the current transformer 4 will also flow through the current transformer 6. Thus, according to well known circuit principles, no current flows through the relay 8. If a fault occurs outside the protected line this situation will not change and the relay 8 will not trip.

However, if a fault occurs within the protected line different currents will flow through each of the current transformers 4, 6 and thus will also flow through the relay 8. In this case the line would be isolated by the trips 10, 12.

The hardwired connections between the two current transformers are generally replaced with a communication link connected to a processing device which monitors the outputs from the current transformers 4, 6 and operates the trips 10, 12 as necessary.

The scheme so far described can in some circumstances be triggered by faults occurring outside the protected line. If large currents are induced in the line by the fault the current transformers 4, 6 can saturate leading to current flowing through the relay 8 and consequent operation of the trips 10, 12.

Therefore, schemes have been proposed which are more robust to false triggerings.

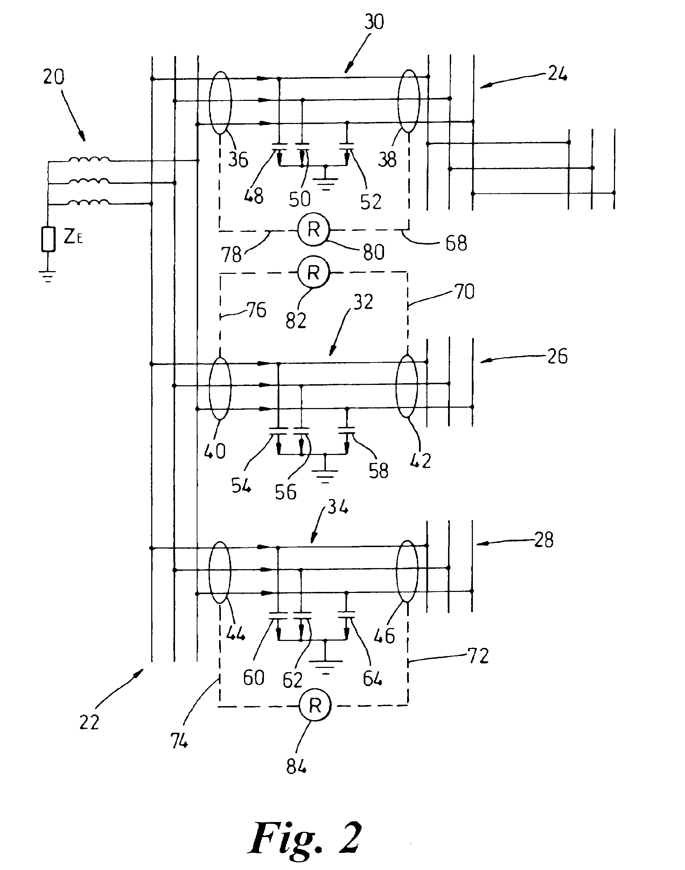

Figure 2 shows a three phase current supply 20, connected to ground through an impedance Z_{E}. The three phase supply is connected to bus bars 22 from which three feeders 30, 32, 34 supply power to further bus bars 24, 26, 28. The three feeders 30, 32, 34 are connected together through the bus bar 22 and therefore a fault in one feeder will affect the current in the others. It is important that a fault in one of the feeders 24, 26, 28 does not cause the remaining feeders to be isolated from the supply 20.

Each of the feeders 24, 26, 28 has a core balance transformer 36, 38, 40, 42, 44, 46 provided at each end region thereof. The core balance transformers 36 to 46 are wound around the three phases and under normal operating conditions will have a substantially zero output since the currents flowing in the three phases sum to zero (I_{A} +I_{B} + I_{C} = 0).

The core balance transformers (36 and 38; 40 and 42; 44 and 46) at each end of a particular feeder are connected via communications links 68-78 to protection relays/processing means 80, 82, 84 which monitor the differential current flowing in the pairs of core balance transformers (36 and 38; 40 and 42; 44 and 46). The relays/processing means 80, 82, 84 are adapted to isolate the feeder they are monitoring should a fault develop. The means for performing this isolation is well known and not shown in the diagram.

Further, the skilled person will appreciate that each of the three phases of each feeder 24, 26, 28 is capacitively coupled to ground and that there will therefore, in an a.c. system, be a current to ground through this capacitive coupling. This capacitive coupling is represented in Figure 2 wherein each phase of each feeder is connected to ground via a capacitor 48-64. The current through the capacitors 48-64 to ground is a function of the impedance of the capacitor and of the line voltage and is therefore independent of the value of Z_{E} (the impedance of the supply 20 to earth), and fault current flowing.

It should be noted in Figure 2 that the currents flowing in the feeders 24, 26, 28 are substantially the same at the core balance transformers at each end of the feeder (i.e. the current is substantially the same at core balance transformers 36 and 38, 40 and 42, 44 and 46).

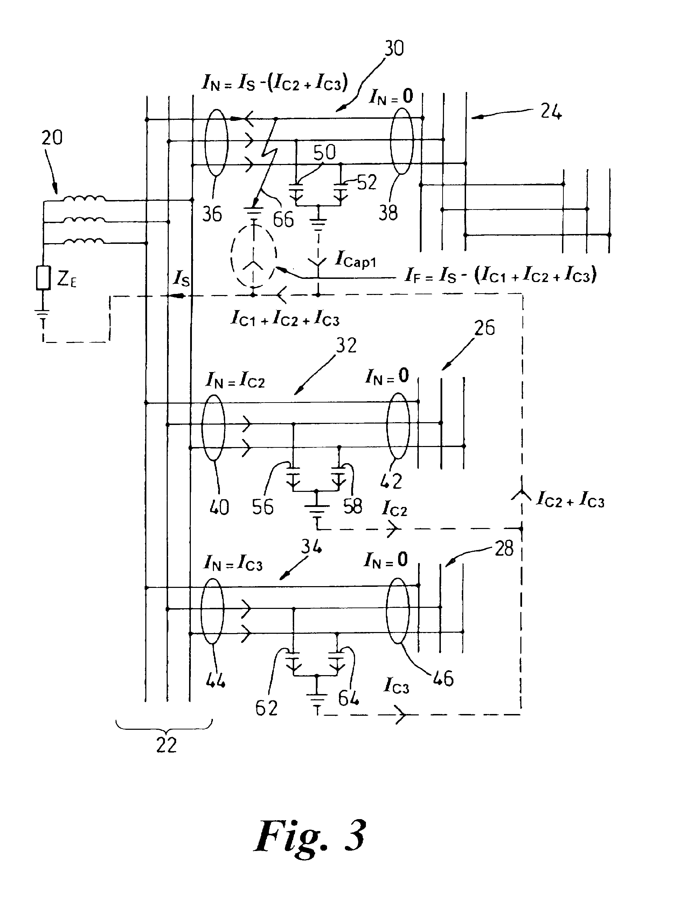

Figure 3 shows the same system (the communication lines 68-78 and relays 80, 82, 84 are not shown for reasons of clarity) as in Figure 2 but with a fault to ground occurring in feeder 30. This fault is represented by the arrow 66. Because there is a direct short to ground from one of the phases the capacitor to ground from that phase is shorted out, in this case capacitor 48. However, because the feeders 30, 32, 34 are connected together through the bus bars 22, the capacitors from equivalent phases of the remaining two feeders 32, 34 are also shorted (that is capacitors 54, 60).

This shorting of capacitors 48, 54, 60 causes different currents to flow through the core balance transformers at each end region of each feeder 30, 32, 34. The various current paths are shown by the dotted lines in Figure 3.

Assuming a fault current IF flows from one of the phases of feeder 30 then a current Is will be caused in the impedance ZE of the source 20. This current Is is the sum of the fault current and the currents caused by the capacitive coupling to ground of the un-faulted phases. This fault current, in combination with the shorting out of capacitors 48, 54, 60 causes differential currents to flow in the pairs of core balance transformers 36, 38; 40 and 42; 44 and 46. These currents are as follows:

### Faulted Feeder.

Current through core balance transformer 36 (on the input of the faulted feeder 30) I_{N} = I_{S} - (I_{C2} + I_{C3}) where I_{c2} is current through capacitors 56, 58 from feeder 32. I_{C3} is current through capacitors 62, 64 from feeder 34. There is zero differential current flowing through core balance transformer 38 (on the output side of the faulted feeder 30).

### 1^{st} Fault Free Feeder.

The differential current induced in core balance transformer 40 (on the input of the fault free feeder 32) is equal to the capacitive current for that feeder, i.e. I_{C2}. Again there is zero differential current detected by core balance transformer 42 (on the output of the fault free feeder 32).

### 2^{nd} Fault Free Feeder.

As with feeder 32, the fault free feeder 34 has a differential current equal to the current flowing through its capacitive coupling i.e. I_{C3} detected at core balance transformer 44 (on the input of the fault free feeder 34), and zero differential current detected at core balance transformers 46 (on the output of the fault free feeder 34).

Thus the fault current is equal to I_{F} = I_{S} - (I_{C1} + I_{C2} + I_{C3}).

In systems where the impedance Z_{E} is low, perhaps wherein a solid earth link is used, the fault current will be large in comparison to I_{C1}, I_{C2}, I_{C3}. Thus, the differential current flowing feeder 30 I_{N} is much larger than the capacitor currents. This situation is easy for the relays 80, 82, 84 to differentiate between a fault condition within the protected line or outside the protected line (i.e. in one of the other feeders).

For example with a low value of Z_{E} the current flowing through Z_{E} may be 1000A under fault conditions. As stated earlier the current to ground through the capacitive coupling is not a function of whether a fault occurs or of Z_{E}. Using an approximation that current through a particular capacitive coupling is 10A, using the formulae derived above the differential current detected at core balance transformer 36 = I_{N} = I_{S} - (I_{cap2} + I_{cap3}) = 980A. The differential currents detected at core balance transformers 40 and 44 on fault free feeders 32, 34 is equal to the current through a single capacitor. I.e. 10A. In such conditions it is easy to set the relays 80, 82, 84 to distinguish between a fault in a particular feeder and one outside that particular feeder. That is there is a large difference in the induced currents between the pairs of core balance transformers 36 and 38; 40 and 42; 44 and 46, in fault free and faulty feeders.

However, distribution networks are known wherein the impedance Z_{E} is either high or approaching infinity. For example systems earthed via Petersen coils or with isolated earths. Such systems are designed to be tolerant to faults and continue to operate with a single fault. However, it is generally important to detect that fault and repair it since this first fault effectively earths the system and therefore if a second fault occurs large currents will again flow because of this effective earth. The high earth impedance prevents large currents from flowing if only a single fault occurs.

In a system with a high earth impedance (i.e. high Z_{E}) or isolated earth there may be zero source current during fault conditions (e.g. Iₛ = 0). Therefore, the differential current in the faulty feeder 30 may be of the order 20A (I_{N} = I_{S} - (I_{C2} + I_{C3}) and noting I_{C2} = I_{C3} = 10A). The differential currents in the fault free feeders 32, 34, will be of the order 10A.

The skilled person will appreciate that it is nearly impossible to set the relays 80, 82, 84 to distinguish between a fault occurring outside the protected line and within the protected line when the differential currents are so close. Thus, the protection system so far described may not operate correctly in systems with high earth impedance or isolated earths.

Therefore, the protection scheme of the present invention is proposed in order to increase the accuracy with which the relays 80, 82, 84 can detect whether or not a fault has occurred within or outside the protected line.

The skilled person will appreciate that in practice the currents flowing to ground from each line, although largely due to capacitive coupling, will include a resistive component. Therefore, the processing means of the fault protection apparatus according to the present invention, processes the information taken from the core balance transformers at each end of the protected line to remove the imaginary current component due to the capacitive coupling. In effect, the processing means looks for current due to a resistive load.

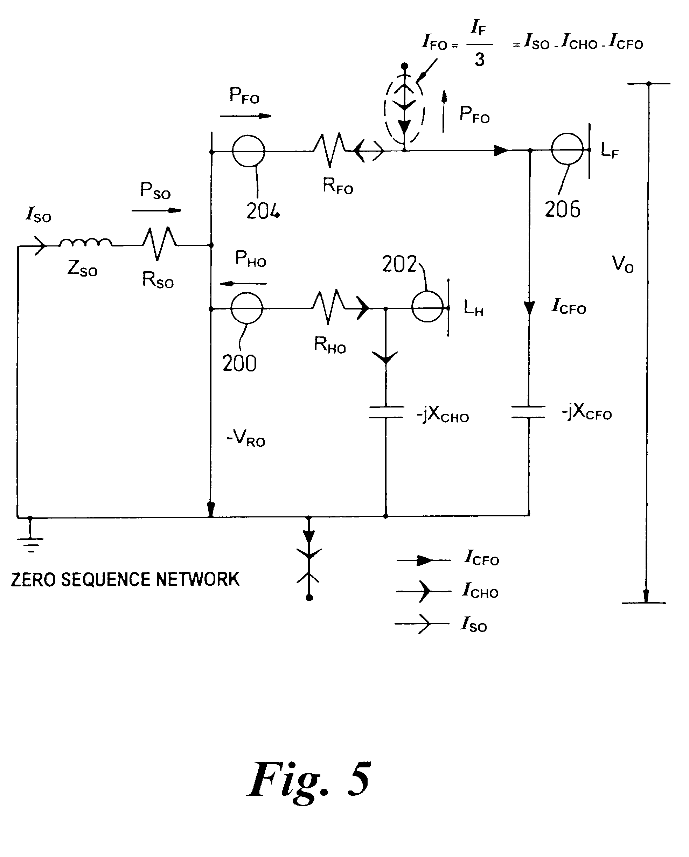

This method of protection may be described as zero sequence power differential protection, and the principles of this are illustrated with reference to Figure 5.

Figure 5 shows the zero sequence network for an earth fault. The line L_{f} is a faulted line and line Lₕ is a healthy line (representing the remainder of the system e.g. feeders 32 and 34 in Figures 2 and 3). The healthy line Lₕ neutral current measured a core balance transformer 200 equals the charging current of that line flowing into the circuit (due to the capacitive/resistive coupling of the line to ground). A core balance transformer 202 at the distal end of the healthy line does not measure any neutral current and therefore the neutral differential current measured by the scheme on line Lₕ is the charging current. This is as described in relation to Figures 2 and 3.

Figure 4 shows a phasor diagram to illustrate this further. In this example an insulated three phase system wherein the source 20 is insulated from ground, has been taken. A phase to earth fault on the A phase results in a rise of the B and C phase voltages. The corresponding capacitive charging currents on these phases I_{bch} and I_{cch} (due to the capacitive coupling of the phases to ground), lead the voltages by 90°. The resulting neutral current, measured by the core balance transformer on the input of the line, (e.g. transformer 36 in Figures 2 and 3 or transformer 204 in Figure 5) will be the sum of I_{bch} and I_{cch} and is shown in Figure 4 as I_{ch1}. As discussed previously this current I_{ch1}, will in practise contain a resistive component, which will tend to make the current I_{ch1} lead by an angle less than 90°. This current is labelled I_{ch2}. The resistive component of the current is labelled Iᵣₑₛᵢₛₜ.

Looking at the zero sequence network of Figure 5 it is apparent that the residual power flow into the faulted feeder P_{FO} is in the opposite direction to the residual power flow into the healthy feeder P_{HO}. As discussed previously, the differential current detected at the core balance transformers 202, 206 is zero, and the differential currents detected at core balance transformer 200, 204 is equal to the capacitive charging current (including resistive component) in the healthy feeder and twice this value in the faulted feeder (assuming insulated earth system). It should be noted that the source current Iₛₒ is essentially zero in such an isolated earth system (see Figure 3). Therefore the current flows in the core balance transformers 200, 204 are in opposite directions.

Therefore, the relays 80, 82, 84 (Fig. 2) detect the phasor relationship between the voltage and current flowing through the core balance transformers to which they are connected. Noting that current flowing through inductive or capacitive impedance will be at 90° to the voltage phasor and can be discounted, the relays 80, 82, 84 isolate the protected line if there is a current component in phase with the residual voltage phasor of the line and above a predetermined threshold. If the feeder is a healthy feeder then the current phasor resistive component will be 180° shifted from the voltage phasor. Thus it is possible to discriminate between healthy and faulty feeders.

## Claims

1. A fault detection apparatus adapted to detect a fault on a line section carrying more than one electrical phase the apparatus having;
detecting means provided at each end of the line section adapted to measure and output the current in the line section;
processing means adapted to measure the outputs from the detecting means; and
said processing means being adapted to calculate for the line section the phasor relationship between the instantaneous current flowing into the line section and the voltage and to determine whether there is a component of the current vector in the same direction as the voltage vector.

2. An apparatus according to claim 1 wherein the voltage detected by the processing means is the instantaneous residual line voltage.

3. An apparatus according to claim 1 or 2 wherein the detecting means comprises one or more transformers.

4. An apparatus according to claim 3 wherein the or each transformer is adapted to measure the neutral current flowing in the line.

5. An apparatus according to any one of the preceding claims wherein the detecting means is a core balance transformer.

6. An apparatus according to any one of the preceding claims wherein the detecting means comprises a transformer provided for each phase of the line.

7. An apparatus according to claim 6 wherein the outputs of these transformers are connected to a star point.

8. An apparatus according to claim 7 wherein the detecting means further comprises a further transformer senses a line connected to the star point.

9. An apparatus according to any one of the preceding claims wherein the apparatus comprises an isolation means adapted to isolate the line.

10. An apparatus according to claim 9 wherein the isolation means isolates the line if current is detected in phase with the residual line voltage.

11. An apparatus according to claim 9 or 10 wherein the isolation means is adapted to be controlled by the processing means.

12. An apparatus according to any one of the preceding claims wherein the processing means comprises thresholding means adapted to trigger the isolation means if the component of current in phase with the line voltage is above a predetermined threshold.

13. An apparatus according to any one of the preceding claims wherein the processing means is adapted to calculate the residual power component in the line due to the component of current in phase with the voltage.

14. An apparatus according to any one of the preceding claims wherein the processing means is provided with an input means.

15. An apparatus according to claim 14 wherein the input means comprises a keyboard, or a keypad or the like.

16. An apparatus according to any one of the preceding claims wherein the apparatus is adapted to protect a three phase line.

17. An apparatus according to any one of the preceding claims wherein the processing means is connected to the detecting means at each end region of the line by a link.

18. An apparatus according to claim 17 wherein the link is a communications link.

19. An apparatus according to claim 18 wherein the communications link is any one of the following: a radio link, microwave link, fibre optic link, cable link, telephone link.

20. A method of detecting a fault on an a.c. line having two or more electrical phases flowing therethrough, the method comprising:
a. detecting the current flowing into and out of the line;
b. determining whether there is an imbalance in the detected currents;
c. if there is an imbalance determining whether there is a component of current in phase with the voltage vector of the line; and
d. if there is a component of current in phase with the voltage determining that a fault is present within that line.

21. A method according to claim 20 comprising isolating the line if a fault is detected within the line.

22. A method according to claim 20 or 21 comprising detecting the neutral current flowing in the line.

23. A method according to any one of claims 20 to 22 comprising discounting capacitive charging current of the line from the current flowing through the line.

24. A method according to claim 23 comprising discounting the capacitive charging current by removing current phasors with a 90° phase shift from the voltage phasor.

25. A method according to any one of claims 20 to 24 comprising thresholding any current detected in phase with the residual voltage on the line and determining that a fault has occurred if the threshold is exceeded.
